# EUROPEAN PATENT APPLICATION

(11) **EP 2 246 903 A1**
(43) Date of publication of application: **03.11.2010**
(21) Application number: 10161320.6
(22) Date of filing: 28.04.2010
(51) Int. Cl.: H01L 31/052

(54) **Lenticular photovoltaic cell**

(30) Priority: 28.04.2009 IT MO20090103
(71) Applicant: Solution e Partners S.r.l., 35042 Este (PD) (IT)
(72) Inventor: Capuzzi, Emidio, 35043, Monselice PD (IT); Pieragostini, Enrico, 37121, Verona (IT); Patorno, Luciano, 41121, Modena (IT); Sighinolfi, Sergio, 41124, Modena (IT)
(74) Representative: Modiano, Micaela Nadia

(57) **Abstract**

A lenticular photovoltaic cell (1), comprising:
- at least one layer of doped semiconductor material in order to provide a p-n junction, a first face (2) of which rests on at least one structure (3) for the containment of the layer;
- at least one lens (4) for concentrating the incident rays of the sun, which is associated with the layer at least at a second face (5) thereof that is designed to be irradiated by direct rays of the sun,
- the lens (4) comprising at least one flat surface (6) that faces the layer and a surface (7) that lies opposite to the flat surface (6) which is formed by a plurality of mutually blended substantially concave surfaces.

## Description

The present invention relates to a lenticular photovoltaic cell.

As is known to the person skilled in the art, photovoltaic panels, used for converting solar energy into electric power, are constituted by a plurality of photovoltaic cells which are mutually connected electrically.

Each one of these photovoltaic cells is constituted in turn by a semiconductor, generally silicon, conveniently doped, generally with boron and phosphorus, so as to obtain a p layer (characterized by an excess of holes and thus of positive charges) and an n layer (characterized by an excess of electrons and thus of negative charges).

An accumulation of charges of opposite sign, and thus an electric field, is created which straddles the p-n junction region that separates such two layers.

The incidence of sunlight on the photovoltaic cells, particularly on their n layer, causes a displacement of electrons and of holes in opposite directions and thus the circulation of electrical current.

Generally, known photovoltaic cells use only the sunlight that strikes directly their n layer and are arranged mutually laterally adjacent so that one face (which corresponds to the respective n layer) is directed toward the sun, and therefore is struck directly by the rays of the sun, and one face (which corresponds to the respective p layer) instead is not reached in a direct manner by the rays of the sun.

Currently, photovoltaic cells use only the solar energy that strikes the respective n layers.

Moreover, the power emitted by each individual photovoltaic cell varies through the day, because the intensity and the wavelength of the incident light varies.

In order to improve the sunlight collection time and the power that can be obtained from the photovoltaic cells, such cells are treated with two methods disclosed in Italian patent applications RM2003A000147 and VR2007A000148.

Moreover, in order to reduce the Joule effect that occurs due to the microscopic potential differences that are present on the surface of the cells, one or more tracks for the flow of current are formed on such cells and one or more current conveyors converge thereon.

It may occur that in order to better utilize the dimensions and the voltage of the cells, such cells are cut into multiple subcells, each comprising a portion of the tracks and of the conveyors mentioned above.

Generally, moreover, photovoltaic panels are mutually arranged in series or in parallel, and are connected electrically to a single inverter adapted to transform the direct current emitted by the individual panels into alternating current available for feeding to the ordinary electric grid.

Since, as mentioned above, the operating conditions of each individual cell change through the day in mutually different ways, the voltage at which the individual cells emit the maximum power (which can be found by means of the V/I characteristic curve known to the person skilled in the art) varies continuously during the day.

The known inverters that are used are characterized by a function, known as MPPT (Maximum Power Point Tracker), that allows the inverter itself to seek continuously the best point of operation by means of continuous retroactive operating voltage variations.

These known photovoltaic cells are not free from drawbacks, among which the fact must be considered that they utilize only the solar energy that strikes directly their n layer.

In order to improve the capacity to collect the solar energy that is incident to the cells it is known to use lenses for focusing the rays of the sun on the active surface of the photovoltaic cell.

These lenses of a known type have convex shapes and in order to have a sufficient concentration efficiency they must have considerable thicknesses and dimensions that extend above the cell itself.

This fact causes the drawback of considerable space occupations of the individual photovoltaic cell and/or of the photovoltaic panel, as well as considerable weights that consequently entail greater dimensions of the supporting structures of the panel itself and often lead to infrequent use of these techniques for collection by means of lenses.

Known photovoltaic cells thus have a limited efficiency.

Another drawback of known photovoltaic panel assemblies is that the surface of each panel available to receive sunlight is generally limited by the presence of external bodies that rest on the panels.

The aim of the present invention is to eliminate the drawbacks cited above of the background art, by devising a lenticular photovoltaic cell that allows to increase the efficiency of the cells with respect to known ones, also by using solar energy.

Within this aim, an object of the present invention is to propose a cell and therefore a photovoltaic panel that has at the same time reduced space occupations and high solar radiation efficiency and thus a high conversion of solar energy into electric power.

Another object is to minimize the dependence of solar radiation and, therefore, of the power conversion mentioned above, on the inclination of the photovoltaic cell and/or of the photovoltaic panel with respect to the rays of the sun that are incident thereto.

Another object of the present invention is to propose a photovoltaic cell that is simple, relatively easy to provide in practice, is safe in use and effective in operation, and has a relatively low cost.

This aim and these and other objects that will become better apparent hereinafter are achieved by the present lenticular photovoltaic cell, comprising:
- at least one layer of doped semiconductor material in order to provide a p-n junction, a first face of which rests on at least one structure for the containment of said layer;
- at least one lens for concentrating the incident rays of the sun, which is associated with said layer at least at a second face thereof that is designed to be irradiated by direct rays of the sun,
   **characterized in that** said lens comprises at least one flat surface that faces said layer and a surface that lies opposite to said flat surface which is formed by a plurality of mutually blended substantially concave surfaces.

Further characteristics and advantages of the present invention will become better apparent from the detailed description that follows of a preferred but not exclusive embodiment of a lenticular photovoltaic cell, illustrated by way of non-limiting example in the accompanying drawings, wherein:

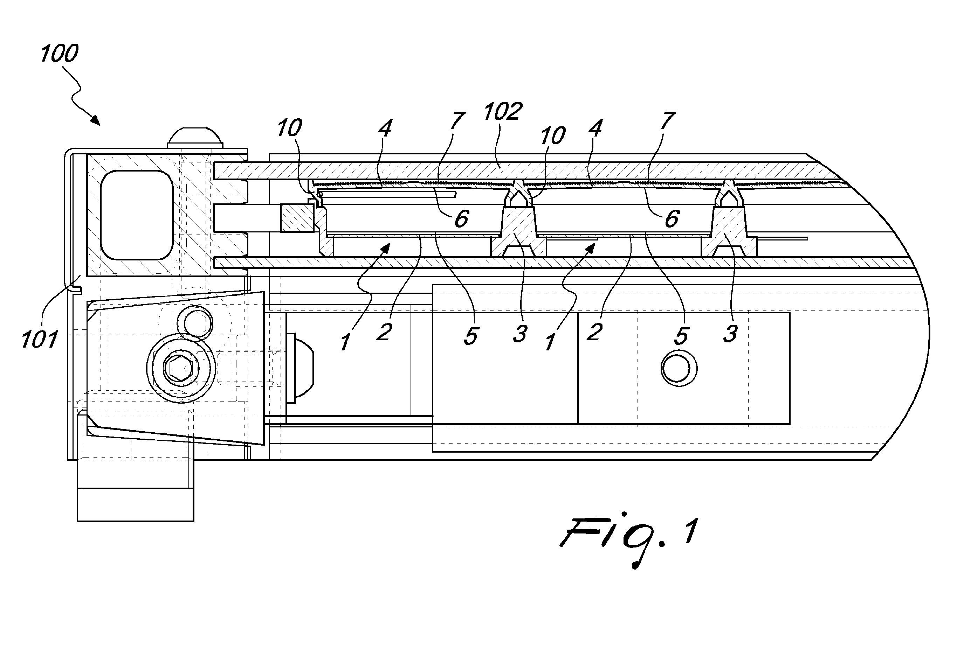

Figure 1 is a schematic sectional view, taken along a longitudinal plane, of a detail of a photovoltaic panel that has a lenticular photovoltaic cell, according to the invention;
Figure 2 is a top view of a lens according to the invention;
Figure 3 is a side view of Figure 2;
Figure 4 is a view of a detail of Figure 3.

With reference to the figures, a lenticular photovoltaic cell according to the invention is generally designated by the reference numeral 1.

The cell 1 comprises at least one layer of doped semiconductor material for providing a p-n junction.

The cell 1 comprises a corresponding n layer and a corresponding p layer made of a semiconductor material, for example doped silicon as known to the person skilled in the art.

The n layers and the p layers are designed to be struck, respectively, by direct sunlight and by diffuse sunlight.

A first face 2 of the layer rests on at least one structure 3 for the containment of such layer.

A photovoltaic panel 100 is provided by means of a plurality of photovoltaic cells 1 which are mutually connected electrically and are mutually jointly connected by means of the containment structure 3.

The cell 1 comprises, moreover, at least one lens 4 for concentrating the incident rays of the sun, which is associated with the layer at least at a second face 5 thereof that is designed to be irradiated by the direct rays of the sun.

In particular, the lens 4 comprises at least one flat surface 6 that faces the layer of the cell 1 with which is associated and a surface 7 that lies opposite the flat surface 6 and is formed by a plurality of mutually blended substantially concave surfaces.

Advantageously, the opposite surface 7 has a transverse cross-section that is shaped like a substantially saw-tooth profile, each tooth having at least one active portion 8, for concentrating the incident rays of the sun, which has a substantially convex surface and a blending portion 9 that is inclined substantially at right angles to the plane formed by the flat surface 6.

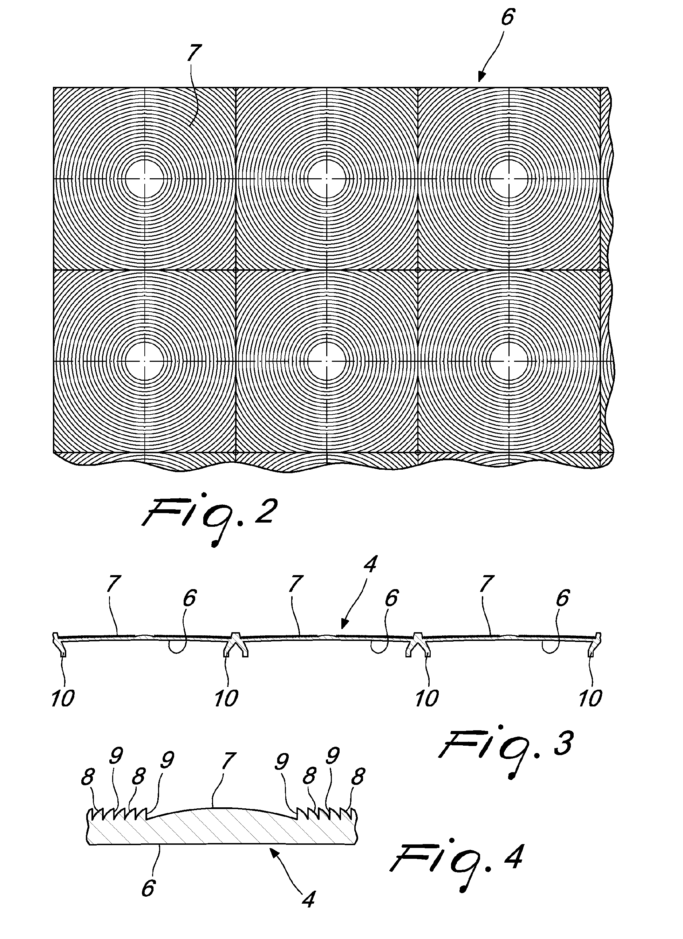

Advantageously, the lens 4 is of the Fresnel lens type obtained by dividing a spherical lens into a series of concentric annular sections, as shown in Figure 2; the Fresnel lens 4 is adapted to increase the collection surface of the p or n layer of the cell 1 with which is associated.

The lens 4 comprises resting contact means 10, which are associated with the flat surface 6 for resting on at least one between the cell 1 and the containment structure 3. The resting contact means are of the type of feet provided for example monolithically with the lens 4.

Advantageously, the lens 4 is made of at least one material that is substantially transparent to solar radiation and with a refractive index comprised between 0.8 and 1.8.

In particular, the lens 4 is made of Perspex^{®}.

A photovoltaic panel 100 comprises a plurality of lenses 4 associated with each cell 1; in the preferred embodiment, the lenses 4 are mutually jointly associated, for example by being provided monolithically, and comprise a plurality of resting contact pins 10. In particular, the lenses 4 are such as to cover the entire active surface of the cells 1 of the photovoltaic panel 100 formed, for example, by the layer p of the cell itself; however, different and equivalent embodiments of the lens 4 are not excluded.

The photovoltaic panel 100 further comprises a structure 101 for supporting the cells 1, of the box-like body type, and at least one protective glass 102 arranged above the lens 4 and jointly associated with the supporting structure 101.

Advantageously the thickness of the lens 4 is comprised between 1 mm and 8 mm, the lens itself having in any case a focal length on the order of 2-8 mm.

In an alternative embodiment, in order to increase the conversion efficiency of the cell 1 it is possible to provide a further lens 4 associated with the layer proximate to the first face 2. In this case the additional lens 4 is arranged symmetrically with respect to the first lens 4 relative to the plane formed by the layer for concentrating diffuse solar radiation on such first face, thus increasing the extension of the collecting surface of the cell 1.

In a preferred embodiment, the photovoltaic panels 100 are provided according to the method described in Patent Application MO2009A000102 in the name of this same Applicant, entitled "Method for providing high-efficiency photovoltaic panels", that provides for doping the n and p layers of the cells that constitute such panel.

The invention thus conceived is susceptible of numerous modifications and variations, all of which are within the scope of the appended claims.

All the details may further be replaced with other technically equivalent elements.

In practice, the materials used, as well as the contingent shapes and dimensions, may be any according to requirements without thereby abandoning the protective scope of the appended claims.

The disclosures in Italian Patent Application no. No. MO2009A000103, from which this application claims priority, are incorporated herein by reference.

Where technical features mentioned in any claim are followed by reference signs, those reference signs have been included for the sole purpose of increasing the intelligibility of the claims and accordingly such reference signs do not have any limiting effect on the interpretation of each element identified by way of example by such reference signs.

## Claims

1. A lenticular photovoltaic cell (1), comprising:
- at least one layer of doped semiconductor material in order to provide a p-n junction, a first face (2) of which rests on at least one structure (3) for the containment of said layer;
- at least one lens (4) for concentrating the incident rays of the sun, which is associated with said layer at least at a second face (5) thereof that is designed to be irradiated by direct rays of the sun,
**characterized in that** said lens (4) comprises at least one flat surface (6) that faces said layer and a surface (7) that lies opposite to said flat surface (6) and is formed by a plurality of mutually blended substantially concave surfaces.

2. The cell (1) according to claim 1, **characterized in that** said opposite surface (7) has a transverse cross-section shaped according to a substantially saw-tooth profile, each tooth having at least one active portion (8) in order to concentrate the rays of the sun with a substantially convex surface and a blending portion (9) that is inclined substantially at right angles to the plane formed by said flat surface (6).

3. The cell (1) according to claims 1 or 2, **characterized in that** said lens (4) is of the Fresnel lens type.

4. The cell (1) according to one or more of the preceding claims, **characterized in that** said lens (4) comprises resting contact means (10) associated with said flat surface (6) for resting contact on at least one between said layer and said containment structure (3).

5. The cell (1) according to one or more of the preceding claims, **characterized in that** said lens (4) is made of at least one material that is substantially transparent to solar radiation and has a refractive index comprised between 0.8 and 1.8.

6. The cell (1) according to one or more of the preceding claims, **characterized in that** said lens (4) is made of Perspex^{®}.

7. The cell (1) according to one or more of the preceding claims, **characterized in that** said lens (4) has a thickness substantially comprised between 1 mm and 8 mm and a focal length substantially comprised between 2 mm and 8 mm.

8. A lenticular photovoltaic panel (100), **characterized in that** it comprises a plurality of cells (1) according to one or more of the preceding claims which are jointly associated with each other.
